# EUROPEAN PATENT SPECIFICATION

(11) **EP 3 352 211 B1**
(45) Date of publication and mention of the grant of the patent: **05.08.2020**
(21) Application number: 17191441.9
(22) Date of filing: 15.09.2017
(51) Int. Cl.: H01L 21/60, H01L 25/075

(54) **METHOD FOR THE FLUIDIC ASSEMBLY OF EMISSIVE DISPLAYS**
VERFAHREN ZUR FLUIDISCHEN ANORDNUNG VON EMISSIONSANZEIGEN
PROCÉDÉ POUR L'ASSEMBLAGE FLUIDIQUE D'ÉCRANS ÉMISSIFS

(30) Priority: 19.01.2017 US 201715410001; 19.01.2017 US 201715410195; 23.01.2017 US 201715412731
(43) Date of publication of application: 25.07.2018
(73) Proprietor: eLux Inc., Camas, WA Washington 98607 (US)
(72) Inventor: SASAKI, Kenji, West Linn, OR 97068 (US); SCHUELE, Paul John, Washougal, WA 98671 (US); ULMER, Kurt, Vancouver, WA 98686 (US); LEE, Jong-Jan, Camas, WA 98607 (US)
(74) Representative: CMS Cameron McKenna Nabarro Olswang LLP

(56) References cited:
- WO-A1-95/17005
- WO-A1-2016/163101
- WO-A1-2017/222960
- JP-A- 2003 216 052
- JP-A- 2004 022 846
- US-A1- 2005 003 570
- US-A1- 2009 230 174
- US-A1- 2010 167 441
- US-A1- 2011 273 410

## Description

### FIELD

This invention relates to a fluidic assembly method for the fabrication of emissive displays.

### BACKGROUND

The fluidic transfer of microfabricated electronic devices, optoelectronic devices, and sub-systems from a donor substrate/wafer to a large area and/or unconventional substrate provides a new opportunity to extend the application range of electronic and optoelectronic devices. For example, display pixel size light emitting diode (LED) micro structures, such as rods, fins, or disks, can be first fabricated on small size wafers and then be transferred to large panel glass substrate to make a direct emitting display. One conventional means of transferring these LED microstructures is through a pick-and-place process. However, with a display comprising millions of elements, such a process may take several hours to complete and is therefore inefficient.

The fluidic self-assembly of electronic devices, such as LEDs and concentrated photovoltaics, is often performed by surface energy minimization at molten solder capillary interfaces so that both mechanical and electrical connections can be made to an electrode during assembly, as demonstrated in US 7,774,929. In one aspect, electronic devices are captured in shape-matched well structures, followed by electrical integration processes, as demonstrated in US 6,316,278.

US2009/230174A1 relates to a self-assembly process. The self-assembly process is disclosed for integrating free standing microcomponents onto a template having a plurality of binding sites, an interconnect network, and trapping structures disposed downstream of the binding sites. The self-assembly is accomplished by flowing a fluid medium containing the microcomponents over the template such that some of the microcomponents are trapped at binding sites. The template may be simultaneously (or subsequently) heated to melt a binder such as a solder spot at each of the binding sites, and then cooled to connect the trapped microcomponents to the interconnect network. In one embodiment, removable blocking elements are disposed upstream of some of the binding sites, for example formed from photoresist. After assembling a first set of microcomponents, the blocking elements are removed, and a second set of microcomponents in a fluid medium are flowed over the template for assembly into the newly unblocked binding sites.

US2011/273410A1 relates to an active matrix LED display apparatus and a fabrication method. The active matrix LED display apparatus enables to miniaturize pixel by a formation of wiring on bottom layer and an assembly of each block through each eutectic layer into each transistor block receptor and/or each LED block receptor formed according to each color element unit, and to be embodied with high luminance, low power consumption, high reliability and superior optical property by assembling a transistor block having high electron mobility. And the fabricating method of the present invention enables to make efficiently an AM-LED display apparatus at room temperature in a short time by using different shapes of receptor and block depending on the function of a transistor and/or on the color of an LED.

WO95/17005A1 relates to a method for assembling microstructures onto a substrate through fluid transport. The microstructures being shaped blocks (19) self-align into recessed regions (55) located on a substrate (50) such that the microstructure becomes integral with the substrate. The improved method includes a step of transferring the shaped blocks into a fluid to create a slurry. Such slurry is then poured evenly over the top surface (53) of a substrate having recessed regions thereon. The microstructure via the shape and fluid tumbles onto the surface of the substrate, self-aligns, and engages into a recessed region.

US2010/167441A1 relates to a method of manufacturing an electronic apparatus, such as a lighting device having light emitting diodes (LEDs) or a power generating device having photovoltaic diodes. The exemplary method includes depositing a first conductive medium within a plurality of channels of a base to form a plurality of first conductors; depositing within the plurality of channels a plurality of semiconductor substrate particles suspended in a carrier medium; forming an ohmic contact between each semiconductor substrate particle and a first conductor; converting the semiconductor substrate particles into a plurality of semiconductor diodes; depositing a second conductive medium to form a plurality of second conductors coupled to the plurality of semiconductor diodes; and depositing or attaching a plurality of lenses suspended in a first polymer over the plurality of diodes. In various embodiments, the depositing, forming, coupling and converting steps are performed by or through a printing process.

US2005/003570A1 relates to a semiconductor device fabrication method. The method uses a fluidic self-assembly technique in which in a liquid, a plurality of semiconductor elements are mounted in a self-aligned manner on a substrate with a plurality of recessed portions formed therein, protruding potions that are inserted in the respective recessed portions of the substrate are formed in the lower portions of the respective semiconductor elements, the liquid in which the semiconductor elements have been spread is poured over the substrate intermittently, and the substrate is rotated in a period of time in which the liquid is not poured.

WO2016/163101A1 relates to a method for forming a direct emission display. The method provides a transparent substrate with an array of wells formed in its top surface. A fluid stream is supplied to the substrate top surface comprising a plurality of top-contact light emitting diode (LED) disks. The wells are filled with the LED disks. A first array of electrically conductive lines is formed over the substrate top surface to connect with a first contact of each LED disk, and a second array of electrically conductive lines is formed over the substrate top surface to connect with a second contact of each LED disk. An insulator over the disk exposes an upper disk (e.g., p-doped) contact region. A via is formed through the disk, exposing a center contact region of a lower (e.g., n-doped) disk contact region. Also provided are a top-contact LED disk and direct emission display.

JP2004-022846A relates to a method of arranging fine components. In this method of arranging fine components, the substrate having one or more recessed sections opened and formed on its upper surface is put in a fluid, and the fine components are arranged in a self-aligning way by scattering the components from above the substrate so that the components may be housed individually in the recessed sections. A GaAs block 101 constituting one of the fine components is composed of a flat plate-shaped block having no inversion symmetry, and the recessed section 115 of an Si substrate 111 is opened to fit the planar shape of the block 101.

JP2003-216052A relates to an element arraying method capable of surely, efficiently and accurately arraying elements on a substrate by self-alignment. Since engaging parts to be engaged with the bottom parts of respective elements are formed on array positions for arraying the elements on the substrate or magnetic films are formed on the bottom parts or side faces of the engaging parts or the n-side electrodes of respective elements, the elements are surely, efficiently and accurately arrayed on the engaging parts of the substrate by applying physical external force such as vibration to the substrate after scattering the elements to the surface of the substrate and the positional deviations of respective elements can be evaded.

Some problems yet to be addressed with conventional fluidic assembly processes are related to the distribution method over large scales, the integration of microcomponents to drive circuitry over large areas, and the potential mechanisms for the repair of defective microcomponents. Over large scales, conventional fluidic assembly into wells is challenged by the dual requirements of maximum velocities for microcomponent capture and minimum distribution velocities for high-speed array assembly. Similarly, achieving the microcomponent dispense scheme and flow velocity uniformity necessary for a high yield over the whole assembly substrate becomes very challenging over greater-than-centimeter scales.

The integration of assembled microcomponents has been primarily done via photolithographically defined electrode deposition for microcomponents, or else by lamination of the second electrical contact in approaches where the first electrode contact is made as part of the assembly scheme. However, the photolithography of large substrates after fluidic assembly is potentially prohibitive due to the contaminating nature of any residual microcomponents on the substrate surface. Laminated top contacts have not demonstrated sufficiently reliable electrical connection to microcomponents for display applications.

Lastly, defect detection of electrically excited microcomponents is the most reliable and robust approach for inspection preceding repair. Assembled microcomponents with top-contact electrodes are at least partially held in an insulating matrix. Any repair that involves removal of defective microcomponents from this matrix is extremely difficult. Moreover, any similarly integrated microcomponents that are added to the array to compensate for defective microcomponents requires that the electrode contact process to be repeated. While technical workarounds may exist, they are expected to be more expensive, more time-intensive, and less reliable.

It would be advantageous if a fluidic assembly process could be used to efficiently transfer emissive elements to a display substrate with a minimum of process steps.

### SUMMARY

The fluidic assembly and orientation approach disclosed herein uses high-variance local forcing on individual microcomponents. The high variance in forcing results in a high variance in velocity such that insofar as a maximum assembly velocity exists for trapping, individual component velocities may fall below that maximum threshold and settle into wells. The second benefit to high variance is that the distribution of components over a large (meter-scale) substrate is relatively quick. Once settled into wells, the maximum forcing is such that assembled components are not dislodged from a correct orientation, but misoriented components are dislodged. This provides for a low-cost, high-speed assembly approach that has achieved an extrapolated assembly rate of over 56 million devices per hour. The assembly method is a general method that may be applicable to any number of substrates but is well suited to low-fill factor, high-area arrays with limited surface topography other than the wells for trapping.

Accordingly, a fluidic assembly method as defined in claim 1 is provided for the fabrication of emissive displays. The liquid suspension may include a solder fluxing agent, or the solder fluxing agent may be applied in a separate step either prior to or subsequent to capturing the emissive elements in the wells and prior to annealing the substrate. Additional process steps may form color modifiers and light diffusers over selected wells.

A eutectic solder interface metal on either the substrate or the emissive element is desirable as well as the use of a fluxing agent prior to thermal anneal. For example, a dimethylammonium chloride, diethanolamine, and glycerol solution may be dissolved in isopropanol. This solution can be used as the assembly fluid (suspension) or it can be introduced after the assembly fluid is removed via sweeping and evaporation.

In accordance with the present invention, the emissive element is a surface mount emissive element such as a light emitting diode (SMLED) with two electrical contacts on its top surface (the SMLED top surfaces faces into the well, adjacent to the bottom surfaces of the wells). The electrical connections between the emissive elements and the well first electrical interfaces are then made without the formation of overlying metal layers, additional conductive traces, or wire bonding on the substrate subsequent to annealing. Other emissive elements such as vertical LEDs (with one electrical contact on the top surface and one electrical contact on the bottom surface), for which additional metallization steps may be required after annealing, do not form part of the present invention. Typically, as emissive elements are captured in the wells, uncaptured emissive elements are simultaneously collected and resuspended for subsequent emissive display fabrication.

In one aspect, an auxiliary mechanism is engaged for distributing the emissive elements over the substrate. Some examples of the auxiliary mechanism include a brush (rotating or non-rotating), wiper, rotating cylinder, pressurized fluid, and mechanical vibration (e.g., acoustic or ultrasonic). The auxiliary mechanism aids in the distribution, of the emissive elements across the substrate surface through contact or engagement with either the emissive elements in the suspension or with the emissive substrate top surface. For example, assuming the emissive substrate has a length and a width, the method flows the suspension across the emissive substrate top surface at a first velocity in a first direction across the length of the emissive substrate. An auxiliary mechanism brush, having a rotation axis and brush length at least equal to the emissive substrate width, translates the brush length across the length of the emissive substrate length in the first direction. Simultaneously with the first pass of brush translation, the brush is rotated to create a first local variance in the first velocity. In one aspect, the brush rotation creates a local variance greater than the first velocity. The method may further repeat the brush translation in the first direction, or in the opposite direction, and the brush rotation may create local variances either greater than or less than the first velocity. The brush may rotate at a rate in the range of 120 to 300 revolutions per minute (RPM) and translate across the emissive substrate top surface at a speed in the range of 3 to 10 centimeter per second (cm/s).

In accordance with the present invention, surface mount emissive elements are fabricated with a post extending from the bottom Then, as the liquid suspension is flowed across the substrate top surface the emissive elements move, at least partially, in response to torque created on the emissive element posts. Perhaps more important, the posts aid in capturing the emissive elements in the wells as a result of surface orienting the emissive element top surfaces directly overlying the well bottom surface.

Additional details of the above-described method, as well as methods for transferring differently shaped emissive elements to an emissive substrate are provided below.

### BRIEF DESCRIPTION OF THE DRAWINGS

Embodiments of the present will now be described, by way of illustration only, with reference to the attached figures.
Fig. 1 is a flowchart illustrating a fluidic assembly method for the fabrication of emissive displays.
Figs. 2A and 2B are, respectively, partial cross-sectional and plan views of an exemplary emissive substrate, not in accordance with the present invention, such as might be provided in Step 102 of Fig. 1.
Fig. 3 is a partial cross-sectional view showing aspects in accordance with the present invention in the performance of Steps 104 through 108 of Fig. 1.
Figs. 4A and 4B are, respectively, partial cross-sectional and plan views depicting surface mount light emitting diode (SMLED) in accordance with an embodiment of the present invention,
Fig. 5 is a perspective view depicting brush auxiliary mechanism in accordance with an embodiment of the present invention.
Fig. 6 is a partial cross-sectional view of an emissive substrate being populated by emissive elements having posts in accordance with an embodiment of the present invention.
Fig. 7 is a flowchart illustrating a fluidic assembly method for the fabrication of emissive displays in accordance with an embodiment of the present invention.
Fig. 8 is a plan view supporting one version of the method described by Fig. 7.
Fig. 9 is a plan view supporting a second version of the method described by Fig. 7.
Fig. 10 is a flowchart illustrating further fluidic assembly method for the fabrication of emissive displays in accordance with an embodiment of the present invention.
Figs. 11A and 11B are, respectively, partial cross-sectional and plan views an emissive substrate, in accordance with the present invention, such as might be provided in Step 102 of Fig. 1.
Figs. 12A and 12B are partial cross-sectional views depicting the function of the post in emissive element surface orientation.
Figs. 13A through 13C are partial cross-sectional views depicting the influence of trapping velocity on the fluidic assembly of emissive elements.
Fig. 14 is a partial cross-sectional view depicting the effect of fluidic assembly suspension fluid drag on emissive element velocity during assembly.

### DETAILED DESCRIPTION

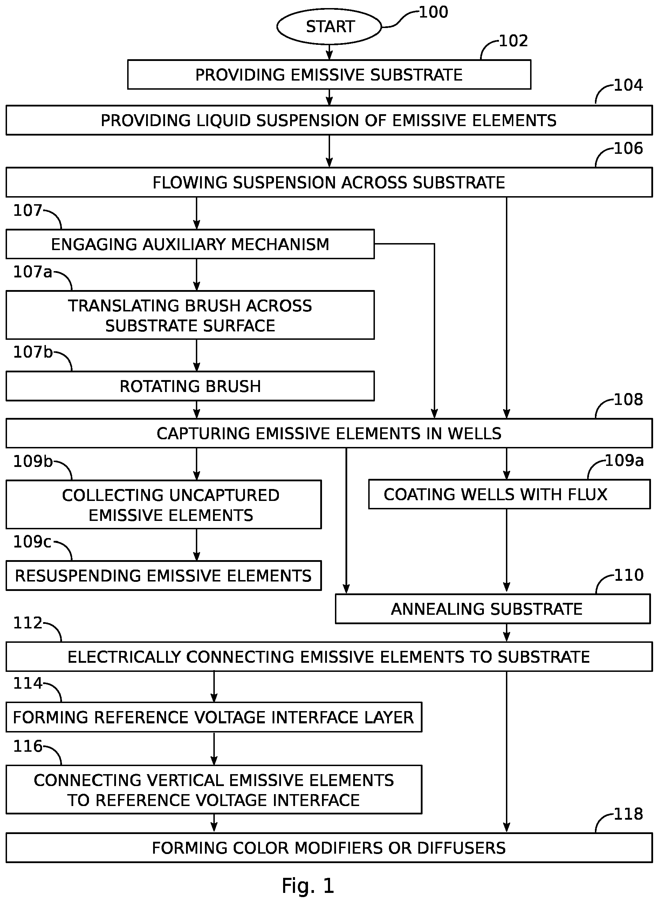

Fig. 1 is a flowchart illustrating a fluidic assembly method for the fabrication of emissive displays. Although the method is depicted as a sequence of numbered steps for clarity, the numbering does not necessarily dictate the order of the steps. It should be understood that some of these steps may be skipped, performed in parallel, or performed without the requirement of maintaining a strict order of sequence. Generally however, the method follows the numeric order of the depicted steps. The method starts at Step 100. Step 102 provides an emissive substrate.

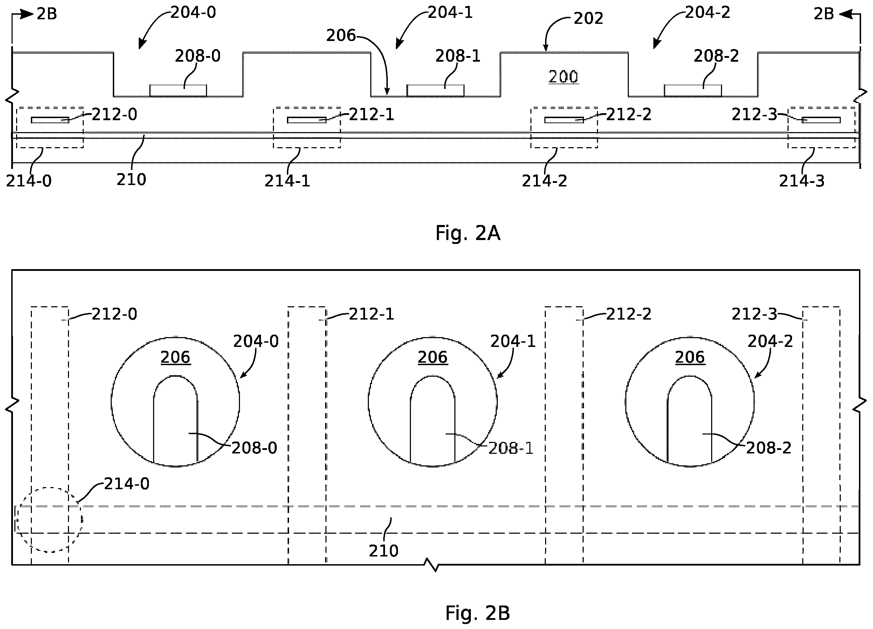

Figs. 2A and 2B are, respectively, partial cross-sectional and plan views of an emissive substrate, not in accordance with the present invention, such as might be provided in Step 102 of Fig. 1.
The emissive substrate 200 has a top surface 202, and a first plurality of wells 204 formed in the top surface (wells 204-0 through 204-2 are shown). Typically, the substrate top surface 202 is planar, and the wells 204 are the only surface topographical feature affecting fluidic assembly. Each well 204 comprises a bottom surface 206 with a first electrical interface 208, which optionally may be solder-coated. First electrical interfaces 208-0 through 208-2 are shown. The emissive substrate is typically transparent and may be a multilayer structure (not shown) comprising a glass substrate with an overlying dielectric material into which the wells have been formed. The emissive substrate 200 also comprises a matrix of column traces 210 and row traces 212 forming a first plurality of column/row intersections 214. Row traces 212-0 through 212-3 are shown, as are column/row intersections 214-0 through 214-2. Each column/row intersection 214 is associated with a corresponding well 204. For example, column/row intersection 214-0 is associated with well 204-0. The column traces 210 and row traces 212 may form a simple passive matrix to selectively enable emissive elements, or be part of an active matrix for the same purpose, as explained in more detail below. For this reason, details of the interconnects between the column, rows, and electrical interfaces are not shown in this drawing.

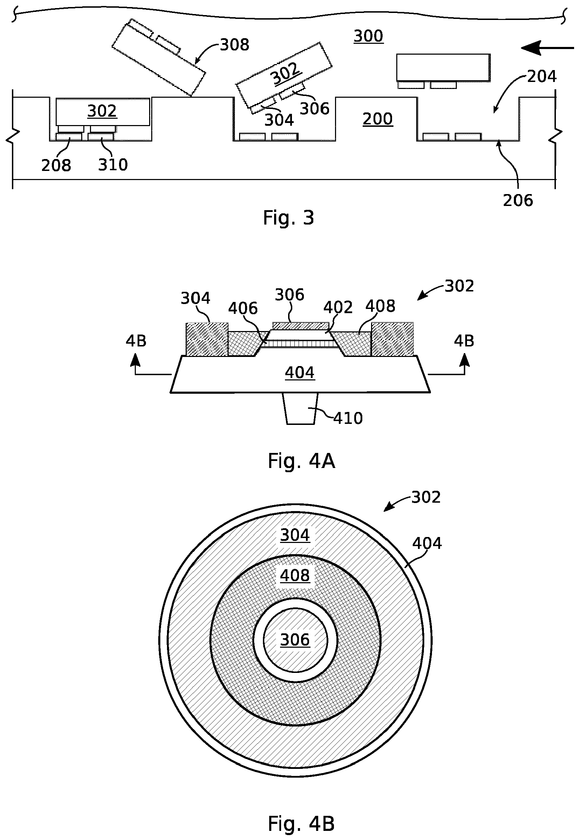

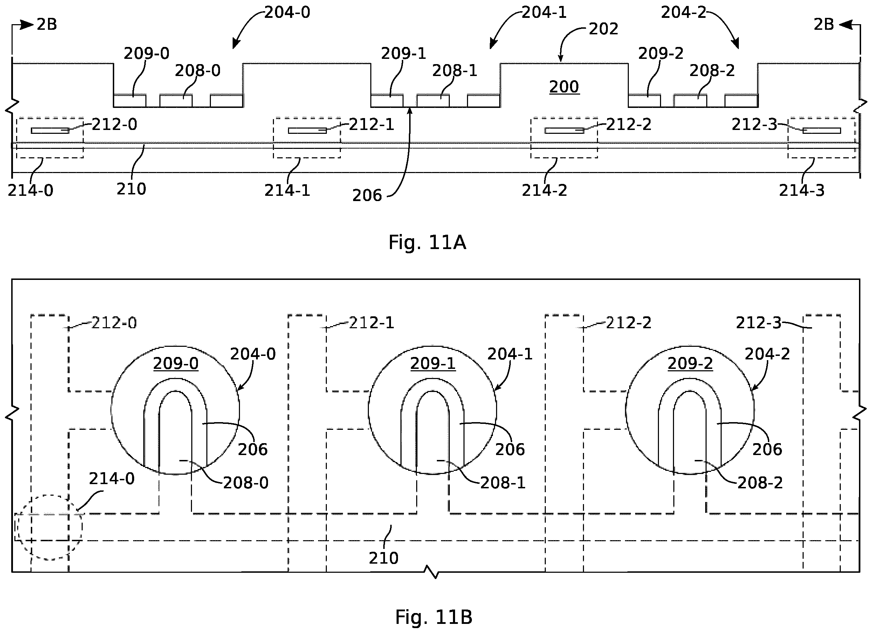

Figs. 11A and 11B are, respectively, partial cross-sectional and plan views of an emissive substrate, in accordance with the present invention, such as might be provided in Step 102 of Fig. 1. In this embodiment, the emissive elements are surface mount light emitting diodes (SMLEDs), as depicted in greater detail in Figs. 4A and 4B. As explained below, the SMLEDs have two electrical contacts on their top surface, which is the surface interfacing the well bottoms 206. As a result, two electrical interfaces are formed on the well bottoms 206; they are first electrical interfaces 208-0 through 208-2 and second electrical interface 209-0 through 209-2. In this aspect the emissive substrate 200 is formed with a passive matrix of column and row traces to selectively enable the SMLEDs. As shown, column trace 210 is connected to the first electrical interface (208-0 through 208-2) in a column of wells 204-0 through 204-2, and row traces 212-0 through 212-2 are respectively connected to the second electrical interfaces (1100-0 through 1100-2) in the column of wells 204-0 through 204-2.

Returning to Fig. 1, Step 104 provides a liquid suspension of emissive elements, and Step 106 flows the suspension across the emissive substrate top surface. The liquid of Step 104 may be one of a number of types of alcohols, polyols, ketones, halocarbons, or water. Step 108 captures the emissive elements in the wells. In one aspect, Step 104 provides a liquid suspension of emissive elements that includes a solder fluxing agent. Alternatively or in addition, subsequent to capturing the emissive elements in the wells (Step 108) and prior to annealing the substrate (Step 110), Step 109a fills the emissive element populated wells with a solder fluxing agent.

Fig. 3 is a partial cross-sectional view showing aspects in accordance with the present invention in the performance of Steps 104 through 108 of Fig. 1. Liquid suspension 300 includes emissive elements 302, some of which are captured in wells 204, with at least an emissive element first electrical contact 304. An emissive element second electrical contact 306 is also shown. Both contacts 304 and 306 are formed on the emissive element top surface 308. Likewise, a second electrical interface 310 is formed on each well bottom surface 206.

Returning to Fig. 1, Step 110 anneals the emissive substrate. In response to the annealing, Step 112 electrically connects each emissive element to the first electrical interface of a corresponding well. As noted above, the well's first electrical interface may be solder coated. Alternatively or in addition, an electrical contact or multiple electrical contacts on the emissive elements may be solder-coated. The annealing is performed at a high enough temperature to melt the solder being used.

A eutectic solder interface metal on either the substrate or the emissive element is desirable as well as the use of a fluxing agent prior to thermal anneal. Using atomic concentrations (at%), Au28/Ge62 solder eutectic has a melting point (MP) of 361 °C, while the melting point for In49/Sn51 solder is 120 °C. Pure indium is 156 °C, but it suffers from the disadvantage of being unable to bond without pressure. The fluxing agent may be a dimethylammonium chloride, diethanolamine, and glycerol solution dissolved in isopropanol, an organic acid, or a rosin-type flux. This solution can be used as the assembly fluid (suspension) or it can be introduced after the assembly fluid is removed via sweeping and evaporation.

Figs. 4A and 4B are, respectively, partial cross-sectional and plan views depicting a surface mount light emitting diode (SMLED) in accordance with an embodiment of the present invention. The emissive elements shown in Fig. 3 may, for example, be SMLEDs. The SMLED 302 comprises a first semiconductor layer 402, with either an n-dopant or a p-dopant. A second semiconductor layer 404 with the dopant not used in the first semiconductor layer 402. A multiple quantum well (MQW) layer 406 is interposed between the first semiconductor layer 402 and the second semiconductor layer 404. The MQW layer 406 may typically be a series of quantum well layers (typically 5 layers - e.g., alternating 5 nm of indium gallium nitride (InGaN) with 9 nm of n-doped GaN (n-GaN)) not shown. There may also be an aluminum gallium nitride (AlGaN) electron blocking layer (not shown) between MQW layers and the p-doped semiconductor layer. The outer layer may be p-doped GaN (Mg doping) about 200 nm thick. A high-brightness blue LED can be formed, or a green LED if a higher indium content is used in the MQW. The most practical first and second semiconductor layer materials are either gallium nitride (GaN), capable of emitting a blue or green light, or aluminum gallium indium phosphide (AlGaInP), capable of emitting red light.

In one aspect, the first electrical contact 304 is configured as a ring, and the second semiconductor layer 404 has a disk shape with a perimeter underlying the first electrical contact ring. The second electrical contact 306 is formed within a first electrical contact 304 ring perimeter, and the first semiconductor layer 402 and MQW layer 406 are a stack underlying the second electrical contact. A moat may be formed between the first electrical contact 304 ring and the second electrical contact 306, filled with an electrical insulator 408. Additional details of the SMLED are provided in the parent application entitled DISPLAY WITH SURFACE MOUNT EMISSIVE ELEMENT, invented by Schuele et al., Serial No. 15/410,001, filed January 19, 2017. Advantageously, if an SMLED is used, then electrically connecting each emissive element in Step 112 includes connecting each emissive element to the first electrical interface without the formation of overlying metal layers, additional conductive traces, wire bonding on the substrate subsequent to annealing, or the application of external pressure on the emissive element. In one aspect as shown, the SMLED includes a post 410 used for alignment and orientation.

More explicitly, Step 102 provides the emissive substrate with wells having a bottom surface with both the first electrical interface and a second electrical interface. If a passive matrix (PM) is used, the column and row traces are connected to the first and second electrical interfaces. If an active matrix (AM) is used, the column and row traces are used to enable a drive circuit associated with each well, whose output is connected to the first electrical interface. In the case of the AM, the matrix of traces in the emissive substrate would further comprise a line connecting dc power to each drive circuit. The emissive substrate would also include a reference voltage network of electrical interfaces connected to each well second electrical interface. Additional details of AM and PM enablement are provided in parent application Serial No. 15/410,001.

Continuing, Step 104 provides a liquid suspension of surface mount emissive elements (e.g., SMLEDs) having a bottom surface and a top surface, with a first electrical contact and a second electrical contact formed on the top surface. Capturing the emissive elements in the wells in Step 108 includes capturing each surface mount emissive element top surface directly overlying a corresponding well bottom surface. Electrically connecting each emissive element to the first electrical interface in the corresponding well in response to the annealing (Step 112) includes electrically connecting each surface mount emissive element first electrical contact to a corresponding well first electrical interface and each emissive element second electrical contact to a corresponding well second electrical interface.

In an example not in accordance with the present invention, Step 104 provides a liquid suspension of vertical emissive elements having a bottom surface with a first electrical contact and a top surface with a second electrical contact. Step 108 captures the emissive element bottom surface directly overlying a corresponding well bottom surface, and Step 112 electrically connects each emissive element first electrical contact to a corresponding well first electrical interface. In this aspect, subsequent to electrically connecting the emissive element first electrical contacts to corresponding well first electrical interfaces in Step 112, Step 114 forms a reference voltage interface layer overlying the emissive substrate top surface. As would be understood in the art, such a step may entail the deposition of an isolation layer over the substrate top surface, and etching to open contact holes through the isolation layer so that the subsequently formed reference voltage interface can be connected to the second electrical contacts. Step 116 connects the second electrical contact of each vertical emissive element to the reference voltage interface layer. For example, thin-film processes can be used to form metallization interconnects over the emissive substrate top surface. In the case of a passive matrix design using vertical emissive elements, a portion of the column/row matrix may be said to be provided in Step 102 (e.g., the column lines) and a portion of the column/row matrix (e.g., the row traces) are provided in Step 114.

In one embodiment of the present invention, Step 107 optionally engages an auxiliary mechanism for distributing the emissive elements. The auxiliary mechanism may, for example, be a brush (rotating or non-rotating), wiper, rotating cylinder, pressurized fluid, or mechanical vibration. A "fluid" may be either a gas or liquid. Examples of mechanical vibration include acoustical and ultrasonic vibration. Then, Step 108 captures the emissive elements, at least partially, in response to the auxiliary mechanism engaging the emissive elements in the suspension or engaging the emissive substrate top surface.

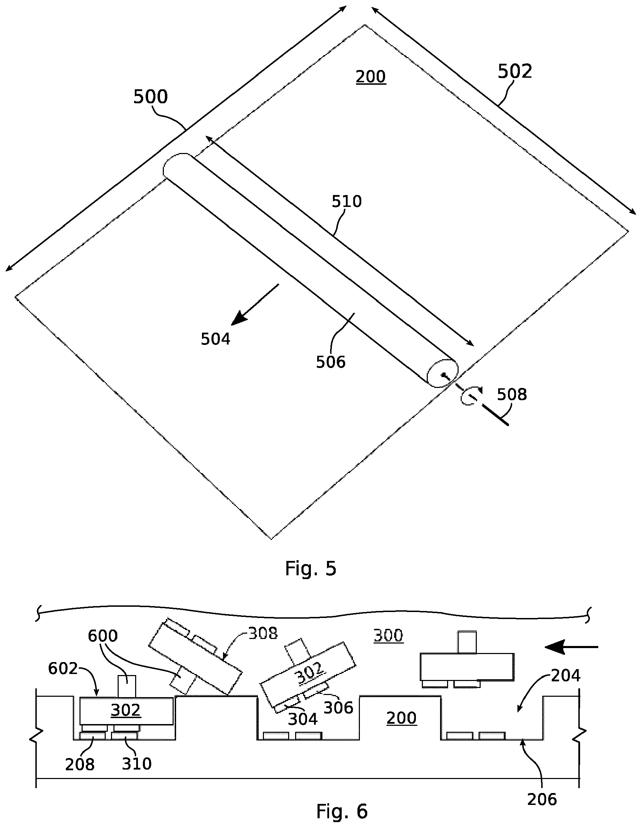

Fig. 5 is a perspective view depicting a brush auxiliary mechanism. Referencing Figs. 1 and 5, Step 102 provides an emissive substrate 200 having a length 500 and a width 502. Step 106 supplies the suspension at a first velocity in a first direction 504 across the length 500 of the emissive substrate 200. Then, Step 107 engages a brush 506, having a rotation axis 508 and brush length 510 at least equal to the emissive substrate width 502 in the following substeps, Step 107a, in a first pass, translates the brush length 510 across the emissive substrate length 500 in the first direction 504. In one embodiment, Step 107a translates the brush at a speed in the range of 3 to 10 centimeter per second (cm/s). Simultaneously with the first pass of brush translation, Step 107b rotates the brush to create a first local variance in the first velocity. As shown, the first local variation is a greater velocity than the first velocity. Alternatively, the first local variation may be lesser velocity than the first velocity. In one aspect, Step 107b rotates the brush at a rate in the range of 120 to 300 revolutions per minute (RPM). In one example, the brush linear velocity at the substrate surface is 35 cm/s, and a low-velocity trapping region occurs in the moving front of suspension pushed out by the brush.

For example, a cylindrical brush used as an auxiliary mechanism may have an outer diameter of 50 mm and be composed of 75 micron diameter nylon or polypropylene bristles in 3 mm tufts arrayed in a close-packed, spiral pattern or two-direction spiral pattern at a 6 mm center-center tuft spacing. These dimensions are given to illustrate a cylindrical brush that has fine, close-packed bristles made of a non-marring material with desirable interactions with both microcomponents and carrier fluid.

In one particular embodiment of the present invention the brush starts at a first edge of the substrate. In a first step, the brush moves to the second edge of the substrate, rotating counterclockwise to increase the local variance. In a second step the brush stops a short distance from second edge, and the rotation reverses to clockwise. In a third step the brush continues move to the second edge, but then reverses translation towards first edge, still rotating clockwise. In a fourth step the brush stops a short distance from the first edge, and rotation reverses to counterclockwise. In a fifth step the brush finishes the translation to the first edge. Optionally, the above-described steps may be repeated.

The first velocity flow speed may be gravity-driven if the substrate is tilted at an angle. The flow velocity may also oscillate or pulse. It should also be appreciated that the velocity of the emissive elements in the suspension is not necessarily the same as the velocity of the liquid. As used herein, the first velocity refers to the liquid velocity.

In one embodiment of the present invention, the liquid suspension disposes a high concentration of ∼2-8 micron thick LEDs with diameters or maximum cross-sectional dimensions of 20 to 150 microns suspended in isopropanol. A low thickness of isopropanol exists over the substrate surface and a horizontal axis brush with nylon or polypropylene bristles rotates close to the surface. The brush is equal in length to one dimension of the substrate and translates across, allowing full coverage of the surface. While translating, the rotation is initially such that the linear velocity of the bristles in contact with the liquid suspension is in the same direction as the translation and of a higher magnitude. In this manner, the brush forces the collection of emissive elements across the substrate surface. Individual emissive elements are generally moved quickly from their point of dislodgment and travel at a significant initial velocity (similar to brush linear velocity) and travel a distance from the brush before settling on the surface again. It is generally this settling that allows assembly into wells.

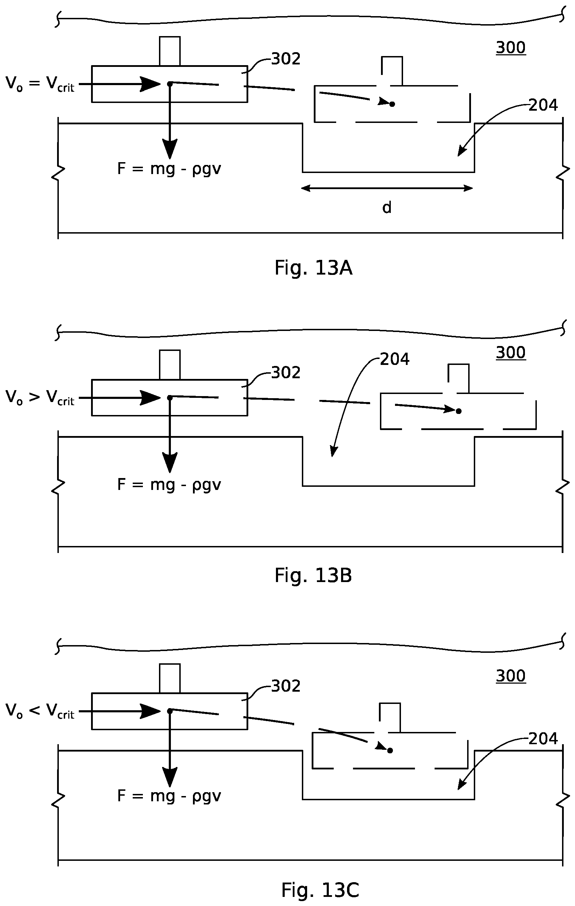

Figs. 13A through 13C are partial cross-sectional views depicting the influence of trapping velocity on the fluidic assembly of emissive elements. At emissive element velocities (Vo) less than or equal to a critical trapping velocity (V_{CRIT}), the emissive elements 302 are moving slow enough to be captured in the wells 204. The critical trapping velocity is represented in the initial condition for a emissive element approaching a trapping site well and, combined with fluid dynamics, emissive element and local substrate topography, and initial component location relative to the well, defines a velocity magnitude above which emissive elements are not captured, and below which, emissive elements are captured. The determining factor is whether or not interaction between the well sidewall and the emissive element provides a stopping force on the emissive element. As such, even if the majority of the emissive element sinks below the plane of the substrate top surface, further fluidic forcing drives the emissive element out of the well if the emissive element leading sidewall edge is wholly above the plane of the substrate top surface. Conversely, if the leading edge of the emissive element is caught by the well sidewall, its momentum is transferred to the substrate and it likely settles into the well. The constant downward force on the emissive elements, which does not include forcing from fluid dynamics, is the gravitational force opposed by the buoyant force exerted by the fluid. As such, V_{CRIT} is determined by fluid density as well as by geometry and initial conditions

The critical trapping velocity is represented in the two dimensions of the figure while, practically, the path of emissive element travel may not be through the well center, and thus include a component moving in or out of the two-dimensional figure. Because the drop of the emissive element prior to contacting the far well sidewall determines whether the emissive element is captured or not, and the on-center approach represents the longest path the emissive element can take without contacting the sidewall, it can be appreciated that significantly lower velocities are required to capture emissive elements that travel off-center of the well. Put another way, the magnitude of the critical trapping velocity is depicted for emissive elements travelling over the center of the well and describes a maximum limit (to the first order) on assembly. To achieve a high yield in practice, minimum emissive element speeds are significantly lower than V_{CRIT} depicted here.

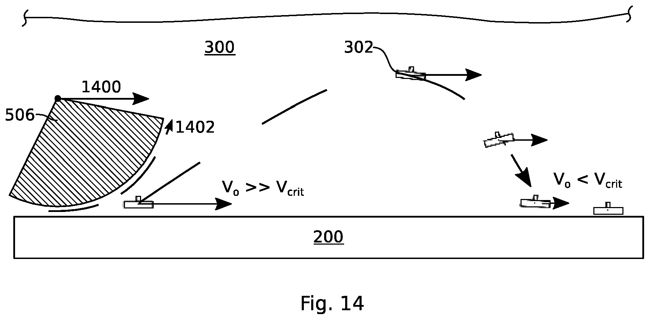

Fig. 14 is a partial cross-sectional view depicting the effect of fluidic assembly suspension fluid drag on emissive element velocity during assembly. At carrier fluid velocities (V) greater than a critical carrier fluid velocity (Vc), the brush 506 is likely to propel an emissive disk up, away from the surface of the substrate 202. As shown, the forces on the emissive element 302 may additionally be a function of the transverse velocity 1400 of the brush 506 and the rotation speed 1402 of the brush. The fluid is likely to be turbulent and to some extent the travel of the emissive elements is independent of the overall fluid flow (beyond the initial brush stroke). Typically, there is a high density of emissive elements near the brushing region that are then scattered forward over the substrate, flow through the fluid and experience drag, slow-down, and finally settle on the surface and into wells before the advancing brush reaches them. So the initial velocity is necessarily very high at the brush, but the emissive elements 302 slow down and settle to velocities below V_{CRIT}, which is a key benefit of the brush approach. A higher speed bristle detraps misoriented disks and pushes a high-density wave front of emissive elements ahead of it, giving them a chance to settle ahead of the brush. The bristle velocity (predominantly from brush rotating speed) is chosen by the detrapping force window for oriented/misoriented disks, and the linear travel velocity of the brush is chosen by the settling time of the emissive elements in liquid. In this way, this assembly approach decouples the individual emissive element assembly speed, which is limited by V_{CRIT}, from the overall display assembly speed, which is fast.

Assembly is rarely complete after a single pass, so additional passes are generally necessary with translation and rotation reversing direction. Translation and rotation need not be reversed at the same time, however. To conserve the population of unassembled components atop the substrate surface (i.e., not located in wells), the rotation reverses first while the brush translates in the same direction as before until all unassembled components are directed back towards the assembly area - at which times the translation of the brush is reversed as well.

In one embodiment of the present invention, the emissive element maximum local density at assembly in one aspect is approximately 0.3 - 0.8 monolayers of components to allow room for settling with a high number of opportunities for capture. As emissive elements are captured, it is desirable to replenish the population of uncaptured (unaligned) emissive elements and fluid with an additional dosing of suspension in front of the moving brush. Good results are obtained with an excess of components - that is, the number of components in liquid suspension over the assembly area exceeds the number of trapping sites by at least 50% to improve capture yield and decrease assembly time. After all sites (wells) are occupied with a correctly oriented emissive element, the excess unassembled components are swept off using the same brushing tool but with a different protocol (e.g. translating the brush with an extent beyond the substrate area with uniform rotation direction). The swept-off components are collected in a reservoir for reuse (Steps 109a and 109b).

A factor that distinguishes this approach is that electrical contact to components does not occur during assembly or solely through deposited metal after assembly, but rather during an anneal that exceeds the eutectic melt temperature of the emissive element-to-substrate interfacing metal. While some prior art methods include fluxing agents such as HCl in aqueous suspensions for molten solder assembly, this approach gradually dissolves solder contacts, making consistent electrical connection to microcomponents difficult. The concentrations of fluxing agents used herein are initially low enough to not be caustic, but during the anneal, residual isopropanol volatilizes first and then glycerol volatilizes. At each step, the concentration of fluxing agents increases, removing surface oxides and contaminants to allow a clean metal surface for bonding. Unlike pick-and-place methods, this approach achieves good electrical contact without applying any external pressure to the component interface.

In one embodiment of the present invention, Step 106 flows the emissive elements in the suspension, where the emissive elements have a higher percentage of occupied volume than the liquid at the emissive substrate top surface. In a related variation, Step 106 flows the suspension across the emissive substrate top surface by creating a maximum local density of emissive elements in the suspension in the range of 0.3 to 0.8 monolayers.

Fig. 6 is a partial cross-sectional view of an emissive substrate being populated by emissive elements having posts in accordance with the present invention. Viewing Figs. 1 and 6, Step 104 provides a liquid suspension of emissive elements 302 with a post 600 extending from the surface 602. Step 106 flows the liquid suspension by moving the emissive elements across the substrate top surface, at least partially, in response to torque created on the emissive element posts 600. Further, capturing the emissive elements in the wells (Step 108) may include surface orienting the surface mount emissive element top surfaces 308 directly overlying the well bottom surface in response to the emissive element posts 600.

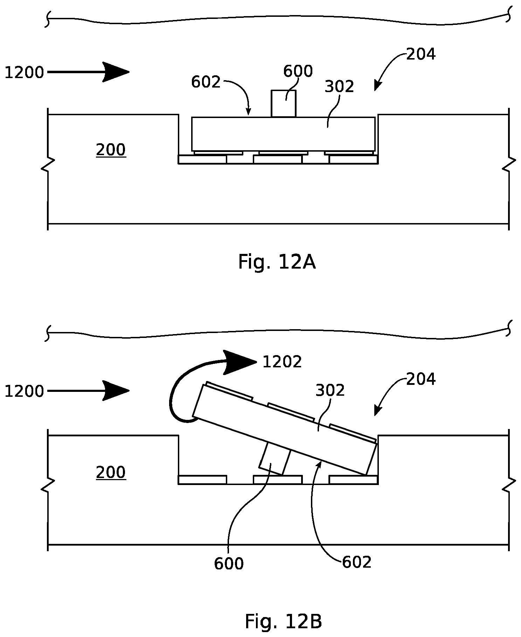

Figs. 12A and 12B are partial cross-sectional views depicting the function of the post in emissive element surface orientation. During fluidic assembly, a liquid flow (indicated by arrows 1200) results in drag forces on the posts 600 of emissive elements 302 traversing the surface of substrate 200. Because a post 600 extends from the emissive element surface 602, the drag forces have an asymmetric impact on the surface orientation of the plate diodes. In particular, the drag forces result in a positive moment of force about a fixed point of rotation (e.g., an edge of the emissive element in contact with the surface of substrate 200) that flip an inverted emissive element 302 into a non-inverted orientation. In contrast, the drag forces on a non-inverted emissive element 302 due to the liquid flow are primarily due to perturbations around post 600, and the forces exerted on the emissive element 302 lead to a negative net moment of force. This negative net moment forces the leading edge (i.e., the edge leading in the direction of arrows 1200) of the emissive element down and stabilizes the emissive element in the non-inverted orientation.

A similar asymmetric impact of the drag forces occurs between an emissive element 302 deposited in a non-inverted orientation in well 204 (see Fig. 12A), and an emissive element deposited in an inverted orientation in the well 204 (see Fig. 12B). As shown in Fig. 12A, any moment of force around the lower right corner of emissive element 302 caused by the liquid flow is offset by forces exerted on surface 602, resulting in a negative net moment of force tending to maintain the emissive element deposited in well 204. As shown in Fig. 12B, when emissive element 302 is inverted in well 204, surface 602 acts as a hydrofoil generating a lifting force from the liquid flow such that a net positive moment of force results around the right side of emissive element 302 contacting the side of well 204. This net positive moment of force tends to cause the emissive element 302 to flip in a direction indicated by an arrow 1202 such that emissive element is forced out of the well 204 and possibly into a non-inverted orientation as the liquid flow moves the emissive element toward another downstream well where it may re-deposit.

In one an embodiment of the present invention, simultaneously with capturing the emissive elements in the wells (Step 108), Step 109b collects the uncaptured emissive elements, and Step 109c resuspends the collected emissive elements for subsequent emissive display fabrication. In another embodiment of the present invention, Step 118 forms a plurality of color modifiers overlying the exposed surfaces of a corresponding plurality of emissive elements. Alternatively or in addition, Step 118 forms a plurality of light diffusers overlying a corresponding plurality of emissive elements.

In accordance with the present invention the emissive element has two bottom contacts (e.g., a SMLED), annealing (Step 110) is the final processing step, save possibly color modification integration and passivation. If electrodes are on opposite surfaces, not in accordance with the present invention, as in the case of a vertical emissive element, a passivation layer is deposited and opened over the emissive element top surface contacts and patterned metal completes electrical connection to the emissive elements (Steps 114 and 116).

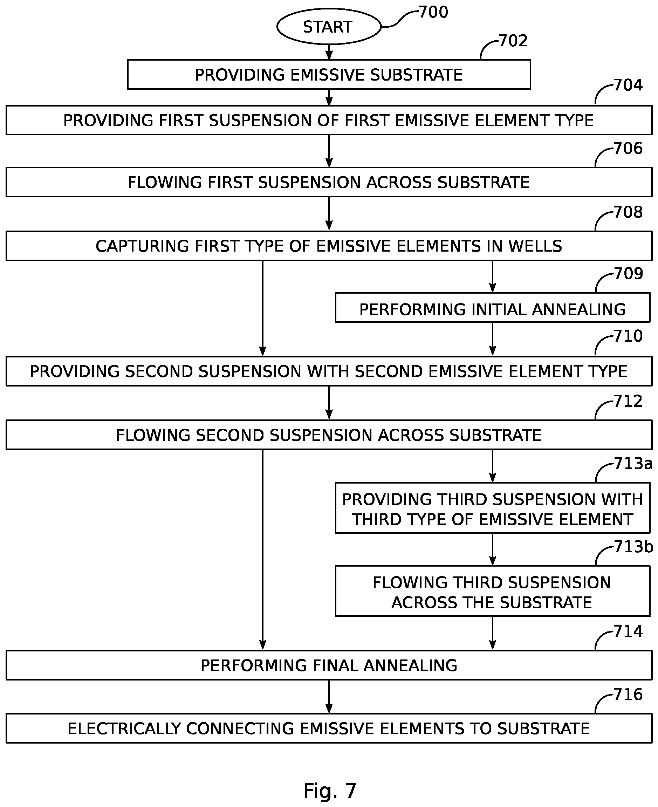

Fig. 7 is a flowchart illustrating a fluidic assembly method for the fabrication of emissive displays in accordance with an embodiment of the present invention. The method begins at Step 700. Step 702 provides an emissive substrate with a top surface, and a plurality of wells formed in the top surface. Each well comprises a bottom surface with a first electrical interface, and the substrate further includes a matrix of column and row traces forming a first plurality of column/row intersections. Each column/row intersection is associated with a corresponding well. Step 704 provides a first liquid suspension with a first type of emissive elements. Step 706 flows the first suspension across the emissive substrate top surface. Step 708 captures the first type of emissive elements in the wells. Step 710 provides a second liquid suspension with a second type of emissive elements. Step 712 flows the second suspension across the emissive substrate top surface. Step 714 performs a final annealing of the emissive substrate. In response to the final annealing, Step 716 electrically connects emissive elements to the first electrical interface of a corresponding well. In one aspect, prior to flowing the second suspension, Step 709 performs an initial annealing to connect the first type of emissive elements to the electrical interfaces of the wells in which they have been captured. Specific details of the fabrication method can be found in the explanation of Fig. 1, above, and are not repeated here in the interest of brevity. In one aspect, the wells in which the second type of emissive elements are captured are formed after Step 708 and before Step 712.

In one embodiment of the present invention prior to the final annealing in Step 714, Step 713a provides a third liquid suspension with a third type of surface mount emissive elements. Step 713b flows the third suspension across the emissive substrate top surface. Although not shown, an additional step after Step 713b may anneal the third type of emissive elements for connection to the electrical interfaces in the wells in which they have been captured. Although not shown, the method can be extended to deposit any number of the emissive element types in a corresponding number of different suspensions.

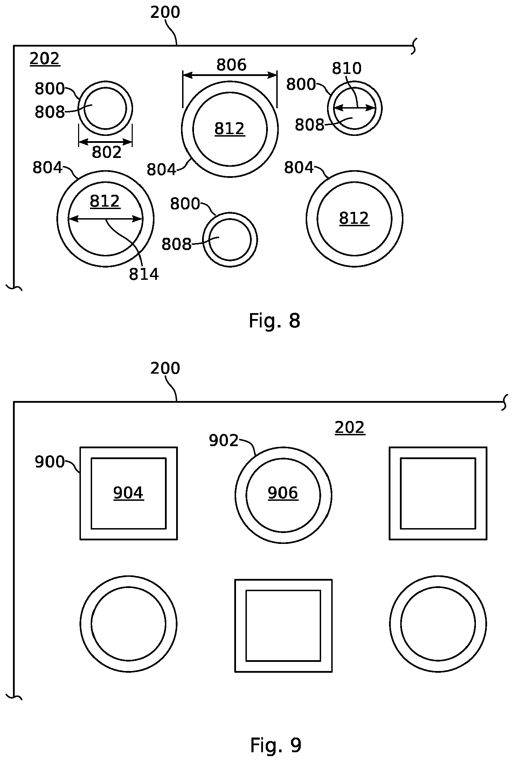

Fig. 8 is a plan view supporting one version of the method described by Fig. 7. Here, Step 702 provides an emissive substrate with a plurality of circular wells 804 having a first diameter 806, and a plurality of circular wells 800 having a second diameter 802, less than the first diameter. Then, the first liquid suspension of Step 704 provides a first type of emissive element disks 812 having a round shape with a third diameter 814 greater than the second diameter 802 and less than the first diameter 806. Step 710 provides a second liquid suspension including a second type of emissive element disks 808 having a round shape with a fourth diameter 810 less than the second diameter 802.

Fig. 9 is a plan view supporting a second version of the method described by Fig. 7. In this embodiment of the present invention, Step 702 provides emissive substrate with a plurality of wells having a first shape 900, and a plurality of wells having a second shape 902, different than the first shape. In this example, the first shape 900 is square and the second shape is circular. However, the method is not limited to any particular shapes or combinations of shapes. Step 704 provides a first liquid suspension with a first type of emissive element having the third shape 904 capable of filling the first shape wells 900, but incapable of filling the second shape wells 902. Step 710 provides a second liquid suspension with a second type of emissive element having a fourth shape 906 capable of filling the second shape wells 902. In one aspect, the emissive elements with the fourth shape 906 are incapable of filling the first shape wells 900.

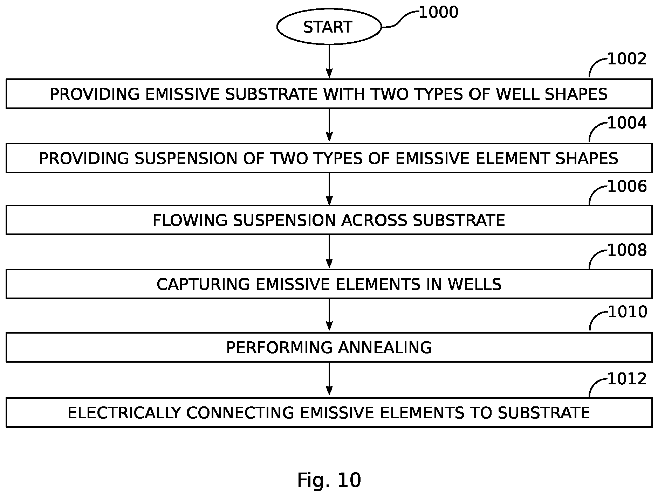

Fig. 10 is a flowchart illustrating a further fluidic assembly method for the fabrication of emissive displays in accordance with an embodiment of the present invention. The method begins at Step 1000. Step 1002 provides an emissive substrate with a top surface, and a plurality of wells having a first shape and a plurality of wells having a second shape, different than the first shape. Each well comprises a bottom surface with a first electrical interface. Step 1002 also provides a matrix of column and row traces forming a first plurality of column/row intersections, where each column/row intersection is associated with a corresponding well. Step 1004 provides a liquid suspension with a first type of emissive element having the third shape capable of filling the first shape wells, but incapable of filling the second shape wells. The liquid suspension of Step 1004 also includes a second type of emissive element having a fourth shape capable of filling the second shape wells, but incapable of filling the first shape wells. Step 1006 flows the suspension across the emissive substrate top surface. Step 1008 captures the first type of emissive elements in the first shape wells and the second type of emissive elements in the second shaped wells. Step 1010 anneals the emissive substrate. In response to the annealing, Step 1012 electrically connects emissive elements to the first electrical interface of a corresponding well.

Fluidic assembly methods for the fabrication of emissive displays in accordance with a number of embodiments of the present invention have been described. Particular materials, dimensions, and circuit layouts have been described to illustrate the invention. However, the invention is not limited to merely these embodiments but defined by the appended claims.

## Claims

1. A fluidic assembly method for the fabrication of emissive displays, the method comprising:
providing an emissive substrate (200) with a top surface (202), a plurality of wells (204) formed in the top surface (202), each well (204) comprising a bottom surface (206) with a first electrical interface (208) and a second electrical interface (209, 310), and a matrix of column and row traces (210, 212) forming a first plurality of column/row intersections (214), where each column/row intersection (214) is associated with a corresponding well (204);
providing a liquid suspension (300) of emissive elements (302);
flowing the suspension (300) across the emissive substrate top surface (202);
capturing the emissive elements (302) in the wells (204);
annealing the emissive substrate (200); and,
in response to the annealing, electrically connecting each emissive element (302) to the first and second electrical interface (208, 209, 310) of a corresponding well (204);
wherein each emissive element (302) is a surface mount emissive element (302) comprising a first and a second electrical contact (304, 306) on a top surface (308) and a post (410, 600) extending from a bottom surface (602),
wherein flowing the liquid suspension (300) across the substrate top surface (202) includes moving the emissive elements (302) across the substrate top surface (302) at least partially in response to torque created on the emissive element posts (410, 600),
wherein capturing the emissive elements (302) in the wells (204) includes surface orienting the emissive element first and second electrical contacts (304, 306) directly overlying a corresponding well bottom surface (206) in response to the emissive element posts (410, 600), and
wherein electrically connecting each emissive element (302) to the first and second electrical interface (208, 209, 310) in the corresponding well (204) in response to the annealing includes electrically connecting each surface mount emissive element first electrical contact (304) to a corresponding well first electrical interface (208) and each emissive element second electrical contact (306) to a corresponding well second electrical interface (209, 310).

2. The method of claim 1 wherein electrically connecting each emissive element (302) includes connecting each emissive element (302) to the first and second electrical interface (208, 209, 310) without the formation of overlying metal layers, additional conductive traces, or wire bonding on the substrate subsequent to annealing.

3. The method of claim 1 further comprising:
engaging an auxiliary mechanism for distributing the emissive elements (302) selected from the group consisting of a rotating or non-rotating brush (506), wiper, rotating cylinder, pressurized fluid, and mechanical vibration; and,
wherein capturing the emissive elements (302) in the wells (204) includes capturing the emissive elements (302) in response to the auxiliary mechanism engaging the emissive elements (302) in the suspension (300) or the emissive substrate top surface (202).

4. The method of claim 3 wherein providing the emissive substrate (200) includes providing an emissive substrate (200) having a length and a width;
wherein flowing the suspension (300) across the emissive substrate top surface (202) includes supplying the suspension (300) at a first velocity in a first direction across the length of the emissive substrate (200);
wherein engaging the auxiliary mechanism includes engaging a brush (506), having a rotation axis (508) and brush length (510) at least equal to the emissive substrate width (502), as follows:
in a first pass, translating the brush length (510) across the emissive substrate length (502) in the first direction;
simultaneously with the first pass of brush translation, rotating the brush (506) to create a first local variance in the first velocity.

5. The method of claim 4 wherein engaging the auxiliary mechanism includes:
rotating the brush (506) at a rate in a range of 120 to 300 revolutions per minute; and,
translating the brush (506) at a speed in a range of 3 to 10 centimeter per second.

6. The method of claim 1 wherein providing the emissive substrate (200) includes a solder-coated first electrical interface (208).

7. The method of claim 1 wherein flowing the suspension (300) across the emissive substrate top surface (202) includes creating a maximum local density of emissive elements (302) in the suspension (300) in a range of 0.3 to 0.8 monolayers.

8. The method of claim 1 wherein electrically connecting each emissive element (302) includes electrical connecting each emissive element (302) to the first and second electrical interface (208, 209, 310) of a corresponding well (204) without the application of external pressure on the emissive element (302).

9. The method of claim 1 wherein providing the liquid suspension (300) of emissive elements (302) comprises providing a suspension (300) including a solder fluxing agent.

10. The method of claim 1 further comprising:
subsequent to capturing the emissive elements (302) in the wells (204) and prior to annealing the substrate (200), filling the emissive element populated wells (204) with a solder fluxing agent.

11. The method of claim 1 further comprising:
simultaneously with capturing the emissive elements (302) in the wells (204), collecting uncaptured emissive elements (302); and,
resuspending the collected emissive elements (302) for subsequent emissive display fabrication.

12. The method of claim 1 further comprising:
forming a plurality of color modifiers overlying the exposed surfaces of a corresponding plurality of emissive elements (302).

13. The method of claim 1 further comprising:
forming a plurality of light diffusers overlying a corresponding plurality of emissive elements (302).

14. The method of claim 1 wherein providing the liquid suspension of emissive elements (302) includes providing a liquid selected from the group consisting of alcohols, polyols, ketones, halocarbons, and water.

15. The method of claim 1 wherein providing the liquid suspension of emissive elements (302) includes providing emissive elements (302) having a solder-coated electrical contact.

16. The method of claim 1 wherein the steps of providing a liquid suspension (300) of emissive elements (302), flowing the suspension (300) across the emissive substrate top surface (202), capturing the emissive elements (302) in the wells (204), and annealing the emissive substrate (200) comprise:
providing a first liquid suspension with a first type of emissive elements (812, 904); flowing the first suspension across the emissive substrate top surface (202);
capturing the first type of emissive elements (812, 904) in the wells (804, 900);
providing a second liquid suspension with a second type of emissive elements (808, 906); flowing the second suspension across the emissive substrate top surface (202);
capturing the second type of emissive elements (808, 906) in the wells (800, 902); and
performing a final annealing of the emissive substrate (200).

17. The method of claim 16 further comprising:
prior to the final annealing, providing a third liquid suspension with a third type of surface mount emissive elements; and,
flowing the third suspension across the emissive substrate top surface (202).

18. The method of claim 16 wherein providing the emissive substrate wells (204) includes providing a plurality of circular wells (804) having a first diameter (806), and providing a plurality of circular wells (800) having a second diameter (802), less than the first diameter (806);
wherein providing the first liquid suspension includes providing a first type of emissive element (812) disks having a round shape with a third diameter (814) greater than the second diameter (802) and less than the first diameter (806); and,
wherein providing the second liquid suspension includes providing a second type of emissive element (808) disks having a round shape with a fourth diameter (810) less than the second diameter (802).

19. The method of claim 16 wherein providing the emissive substrate wells (204) includes providing a plurality of wells having a first shape (900), and providing a plurality of wells having a second shape (902), different than the first shape (900);
wherein providing the first liquid suspension includes providing a first type of emissive element having the third shape (904) capable of filling the first shape wells (900), but incapable of filling the second shape wells (902); and,
wherein providing the second liquid suspension includes providing a second type of emissive element having a fourth shape (906) capable of filling the second shape wells (902).

20. The method of claim 16 further comprising:
prior to flowing the second suspension, performing an initial annealing.

21. The method of claim 1 wherein the steps of providing an emissive substrate (200), providing a liquid suspension (300) of emissive elements (302), and capturing the emissive elements (302) in the wells (204), comprise:
providing a plurality of wells having a first shape (900) and a plurality of wells having a second shape (902), different than the first shape (900);
providing a liquid suspension (300) of a first type of emissive elements and a second type of emissive elements wherein each of the first type of emissive elements has a third shape (904) capable of filling the first shape wells (900), but incapable of filling the second shape wells (902) and each of the second type of emissive elements has a fourth shape (906) capable of filling the second shape wells (902), but incapable of filling the first shape wells (900); and
wherein capturing the first type of emissive elements in the wells and capturing the second type of emissive elements in the wells include capturing the first type of emissive elements in the first shape wells (900) and the second type of emissive elements in the second shaped wells (902).

## Patentansprüche

1. Fluidisches Anordnungsverfahren für die Herstellung von emittierenden Displays, wobei das Verfahren Folgendes umfasst:
Bereitstellen eines emittierenden Substrats (200) mit einer oberen Oberfläche (202), mehreren Vertiefungen (204), die in der oberen Oberfläche (202) ausgebildet sind, wobei jede Vertiefung (204) eine untere Oberfläche (206) mit einer ersten elektrischen Schnittstelle (208) und einer zweiten elektrischen Schnittstelle (209, 310), und einer Matrix von Spalten- und Zeilenspuren (210, 212), die erste mehrere Spalten-/Zeilenschnittpunkte (214) ausbilden, umfasst, wobei jeder Spalten-/Zeilenschnittpunkt (214) einer entsprechenden Vertiefung (204) zugeordnet ist;
Bereitstellen einer flüssigen Suspension (300) von emittierenden Elementen (302);
Fließen der Suspension (300) über die obere Oberfläche (202) des emittierenden Substrats ;
Einfangen der emittierenden Elemente (302) in den Vertiefungen (204); Glühen des emittierenden Substrats (200); und,
als Reaktion auf das Glühen, elektrisches Verbinden jedes emittierenden Elements (302) mit der ersten und der zweiten elektrischen Schnittstelle (208, 209, 310) einer entsprechenden Vertiefung (204);
wobei
jedes emittierende Element (302) ein oberflächenmontiertes emittierendes Element (302) ist, das einen ersten und einen zweiten elektrischen Kontakt (304, 306) auf einer oberen Oberfläche (308) und einen sich von einer unteren Oberfläche (602) erstreckenden Stift (410, 600) umfasst,
wobei das Fließen der flüssigen Suspension (300) über die obere Oberfläche (202) des Substrats das Bewegen der emittierenden Elemente (302) über die obere Oberfläche (302) des Substrats mindestens teilweise als Reaktion auf ein an den Stiften (410, 600) der emittierenden Elemente erzeugtes Drehmoment beinhaltet, wobei das Einfangen der emittierenden Elemente (302) in den Vertiefungen (204) eine Oberflächenausrichtung des ersten und des zweiten elektrischen Kontakts (304, 306) des emittierenden Elements beinhaltet, die als Reaktion auf die Stifte (410, 600) des emittierenden Elements direkt über einer entsprechenden unteren Vertiefungsoberfläche (206) liegen, und
wobei das elektrische Verbinden jedes emittierenden Elements (302) mit der ersten und der zweiten elektrischen Schnittstelle (208, 209, 310) in der entsprechenden Vertiefung (204) als Reaktion auf das Glühen das elektrische Verbinden eines ersten elektrischen Kontakts (304) jedes oberflächenmontierten emittierenden Elements mit einer entsprechenden ersten elektrischen Schnittstelle (208) der Vertiefung und eines zweiten elektrischen Kontakts (306) jedes emittierenden Elements mit einer entsprechenden zweiten elektrischen Schnittstelle (209, 310) der Vertiefung beinhaltet.

2. Verfahren nach Anspruch 1, wobei das elektrische Verbinden jedes emittierenden Elements (302) das Verbinden jedes emittierenden Elements (302) mit der ersten und der zweiten elektrischen Schnittstelle (208, 209, 310) ohne die Ausbildung von darüberliegenden Metallschichten, zusätzlichen Leiterbahnen oder Drahtbonden auf dem Substrat nach dem Glühen beinhaltet.

3. Verfahren nach Anspruch 1, ferner Folgendes umfassend:
Eingreifen eines Hilfsmechanismus zum Verteilen der emittierenden Elemente (302), die aus der Gruppe ausgewählt sind, die aus einem rotierenden oder nicht rotierenden (506), Wischer, rotierenden Zylinder, Druckfluid und mechanischer Vibration besteht; und,
wobei das Einfangen der emittierenden Elemente (302) in den Vertiefungen (204) das Einfangen der emittierenden Elemente (302) als Reaktion auf den Hilfsmechanismus, der mit den emittierenden Elementen (302) in der Suspension (300) oder der oberen Oberfläche (202) des emittierenden Substrats in Eingriff steht, beinhaltet.

4. Verfahren nach Anspruch 3, wobei das Bereitstellen des emittierenden Substrats (200) das Bereitstellen eines emittierenden Substrats (200), das eine Länge und eine Breite aufweist, beinhaltet;
wobei das Fließen der Suspension (300) über die obere Oberfläche (202) des emittierenden Substrats das Zuführen der Suspension (300) bei einer ersten Geschwindigkeit in einer ersten Richtung über die Länge des emittierenden Substrats (200) beinhaltet;
wobei das Eingreifen des Hilfsmechanismus das Eingreifen einer Bürste (506), die eine rotierende Achse (508) und eine Bürstenlänge (510) aufweist, die mindestens gleich der Breite (502) des emittierenden Substrats ist, beinhaltet, wie folgt umfasst:
in einem ersten Durchgang, Verschieben der Bürstenlänge (510) über die Länge (502) des emittierenden Substrats in der ersten Richtung;
gleichzeitig mit dem ersten Durchgang der Bürstenverschiebung, Rotieren der Bürste (506), um eine erste lokale Varianz in der ersten Geschwindigkeit zu erzeugen.

5. Verfahren nach Anspruch 4, wobei das Eingreifen des Hilfsmechanismus Folgendes beinhaltet:
Rotieren der Bürste (506) bei einer Geschwindigkeit in einem Bereich von 120 bis 300 Umdrehungen pro Minute; und,
Verschieben der Bürste (506) bei einer Geschwindigkeit in einem Bereich von 3 bis 10 Zentimetern pro Sekunde.

6. Verfahren nach Anspruch 1, wobei das Bereitstellen des emittierenden Substrats (200) eine lötmittelbeschichtete erste elektrische Schnittstelle (208) beinhaltet.

7. Verfahren nach Anspruch 1, wobei das Fließen der Suspension (300) über die obere Oberfläche (202) des emittierenden Substrats das Erzeugen einer maximalen lokalen Dichte von emittierenden Elementen (302) in der Suspension (300) in einem Bereich von 0,3 bis 0,8 Monoschichten beinhaltet.

8. Verfahren nach Anspruch 1, wobei das elektrische Verbinden jedes emittierenden Elements (302) das elektrische Verbinden jedes emittierenden Elements (302) mit der ersten und der zweiten elektrischen Schnittstelle (208, 209, 310) einer entsprechenden Vertiefung (204) ohne die Anwendung von äußerem Druck auf das emittierende Element (302) beinhaltet.

9. Verfahren nach Anspruch 1, wobei das Bereitstellen der flüssigen Suspension (300) von emittierenden Elementen (302) das Bereitstellen einer Suspension (300), die ein Lötflussmittel beinhaltet, umfasst.

10. Verfahren nach Anspruch 1, ferner Folgendes umfassend:
nach dem Einfangen der emittierenden Elemente (302) in den Vertiefungen (204) und vor dem Glühen des Substrats (200), Füllen der mit dem emittierenden Element bestückten Vertiefungen (204) mit einem Lötflussmittel.

11. Verfahren nach Anspruch 1, ferner Folgendes umfassend:
gleichzeitig mit dem Einfangen der emittierenden Elemente (302) in den Vertiefungen (204), Sammeln nicht eingefangener emittierender Elemente (302); und,
Resuspendieren der gesammelten emittierenden Elemente (302) für die nachfolgende Herstellung von emittierenden Displays.

12. Verfahren nach Anspruch 1, ferner Folgendes umfassend:
Ausbilden mehrerer Farbmodifikatoren, die über den freiliegenden Oberflächen von entsprechenden mehreren emittierenden Elementen (302) liegen.

13. Verfahren nach Anspruch 1, ferner Folgendes umfassend:
Ausbilden mehrerer Lichtdiffusoren, die über entsprechenden mehreren von emittierenden Elementen (302) liegen.

14. Verfahren nach Anspruch 1, wobei das Bereitstellen der flüssigen Suspension von emittierenden Elementen (302) das Bereitstellen einer Flüssigkeit, die aus der Gruppe ausgewählt ist, die aus Alkoholen, Polyolen, Ketonen, Halogenkohlenwasserstoffen und Wasser besteht, beinhaltet.

15. Verfahren nach Anspruch 1, wobei das Bereitstellen der flüssigen Suspension von emittierenden Elementen (302) das Bereitstellen von emittierenden Elementen (302), die einen lötmittelbeschichteten elektrischen Kontakt aufweist, beinhaltet.

16. Verfahren nach Anspruch 1, wobei die Schritte des Bereitstellens einer flüssigen Suspension (300) von emittierenden Elementen (302), des Fließens der Suspension (300) über die obere Oberfläche (202) des emittierenden Substrats, des Einfangens der emittierenden Elemente (302) in den Vertiefungen (204) und des Glühens des emittierenden Substrats (200) Folgendes umfassen:
Bereitstellen einer ersten flüssigen Suspension mit einer ersten Art von emittierenden Elementen (812, 904);
Fließen der ersten Suspension über die obere Oberfläche des emittierenden Substrats (202);
Einfangen der ersten Art von emittierenden Elementen (812, 904) in den Vertiefungen (804, 900);
Bereitstellen einer zweiten flüssigen Suspension mit einer zweiten Art von emittierenden Elementen (808, 906);
Fließen der zweiten Suspension über die obere Oberfläche des emittierenden Substrats (202);
Einfangen der zweiten Art von emittierenden Elementen (808, 906) in den Vertiefungen (800, 902); und
Durchführen eines abschließenden Glühens des emittierenden Substrats (200).

17. Verfahren nach Anspruch 16, ferner Folgendes umfassend:
vor dem abschließenden Glühen, Bereitstellen einer dritten flüssigen Suspension mit einer dritten Art von oberflächenmontierten emittierenden Elementen; und,
Fließen der dritten Suspension über die obere Oberfläche des emittierenden Substrats (202).

18. Verfahren nach Anspruch 16,
wobei das Bereitstellen der emittierenden Substratvertiefungen (204) das Bereitstellen mehrerer kreisförmiger Vertiefungen (804), die einen ersten Durchmesser (806) aufweisen, und das Bereitstellen mehrerer kreisförmiger Vertiefungen (800), die einen zweiten Durchmesser (802) aufweisen, der kleiner als der erste Durchmesser (806) ist, beinhalten;
wobei das Bereitstellen der ersten flüssigen Suspension das Bereitstellen einer ersten Art von Scheiben mit einem emittierenden Element (812), die eine runde Form, die einen dritten Durchmesser (814) aufweist, der größer als der zweite Durchmesser (802) und kleiner als der erste Durchmesser (806) ist, beinhaltet; und,
wobei das Bereitstellen der zweiten flüssigen Suspension das Bereitstellen einer zweiten Art von Scheiben (808) mit emittierendem Element, die eine runde Form, die einen vierten Durchmesser (810) aufweist, der kleiner als der zweite Durchmesser (802) ist, beinhaltet.

19. Verfahren nach Anspruch 16,
wobei das Bereitstellen der emittierenden Substratvertiefungen (204) das Bereitstellen mehrerer Vertiefungen, die eine erste Form (900) aufweisen, und das Bereitstellen mehrerer Vertiefungen, die eine zweite Form (902) aufweisen, die sich von der ersten Form (900) unterscheidet, beinhaltet;
wobei das Bereitstellen der ersten flüssigen Suspension das Bereitstellen einer ersten Art von einem emittierenden Element, das die dritte Form (904) aufweist, beinhaltet, das in der Lage ist, die Vertiefungen der ersten Form (900) zu füllen, jedoch nicht in der Lage ist, die Vertiefungen (902) der zweiten Form zu füllen; und,
wobei das Bereitstellen der zweiten flüssigen Suspension das Bereitstellen einer zweiten Art von einem emittierenden Element, das eine vierte Form (906) aufweist, beinhaltet, das in der Lage ist, die Vertiefungen (902) der zweiten Form zu füllen.

20. Verfahren nach Anspruch 16, ferner Folgendes umfassend:
vor dem Fließen der zweiten Suspension, Ausführen eines anfänglichen Glühens.

21. Verfahren nach Anspruch 1, wobei die Schritte des Bereitstellens eines emittierenden Substrats (200), des Bereitstellens einer flüssigen Suspension (300) von emittierenden Elementen (302) und des Einfangens der emittierenden Elemente (302) in den Vertiefungen (204) Folgendes umfassen:
Bereitstellen mehrerer Vertiefungen, die eine erste Form (900) aufweisen, und mehrerer Vertiefungen, die eine zweite Form (902) aufweisen, die sich von der ersten Form (900) unterscheidet;
Bereitstellen einer flüssigen Suspension (300) einer ersten Art von emittierenden Elementen und einer zweiten Art von emittierenden Elementen,
wobei jedes der emittierenden Elemente der ersten Art eine dritte Form (904) aufweist, das in der Lage ist, die Vertiefungen der ersten Form (900) zu füllen, jedoch nicht in der Lage ist, die Vertiefungen (902) der zweiten Form zu füllen, und wobei jedes der zweiten Art von emittierenden Elementen eine vierte Form (906) aufweist, das in der Lage ist, die Vertiefungen (902) der zweiten Form zu füllen, jedoch nicht in der Lage ist, die Vertiefungen der ersten Form (900) zu füllen; und
wobei das Einfangen der ersten Art von emittierenden Elementen in den Vertiefungen und das Einfangen der zweiten Art von emittierenden Elementen in den Vertiefungen das Einfangen der ersten Art von emittierenden Elementen in den Vertiefungen mit der ersten Form (900) und der zweiten Art von emittierenden Elementen in den Vertiefungen mit der zweiten Form (902) beinhaltet.

## Revendications

1. Procédé d'assemblage fluidique destiné à la fabrication de dispositifs d'affichage émissifs, le procédé comprenant :
la fourniture d'un substrat émissif (200) ayant une surface supérieure (202), une pluralité de puits (204) formés dans la surface supérieure (202), chaque puits (204) comprenant une surface inférieure (206) ayant une première interface électrique (208) et une seconde interface électrique (209, 310), et une matrice de traces de colonne et de ligne (210, 212) formant une première pluralité d'intersections colonne/ligne (214), où chaque intersection colonne/ligne (214) est associée à un puits correspondant (204) ;
la fourniture d'une suspension liquide (300) d'éléments émissifs (302) ;
l'écoulement de la suspension (300) à travers la surface supérieure du substrat émissif (202) ;
la capture des éléments émissifs (302) dans les puits (204) ;
le recuit du substrat émissif (200) ; et,
en réponse au recuit, la connexion électrique de chaque élément émissif (302) aux première et seconde interfaces électriques (208, 209, 310) d'un puits correspondant (204) ;
chaque élément émissif (302) étant un élément émissif de montage en surface (302) comprenant un premier et un second contact électrique (304, 306) sur une surface supérieure (308) et une pointe (410, 600) s'étendant à partir d'une surface inférieure (602),
l'écoulement de la suspension liquide (300) à travers la surface supérieure du substrat (202) comportant le déplacement des éléments émissifs (302) à travers la surface supérieure du substrat (302) au moins partiellement en réponse au couple créé sur les pointes de l'élément émissif (410, 600),
la capture des éléments émissifs (302) dans les puits (204) comportant l'orientation de la surface des premier et second contacts électriques de l'élément émissif (304, 306) recouvrant directement une surface inférieure de puits correspondant (206) en réponse aux pointes de l'élément émissif (410, 600), et
la connexion électrique de chaque élément émissif (302) aux première et seconde interfaces électriques (208, 209, 310) dans le puits correspondant (204) en réponse au recuit comportant la connexion électrique de chaque premier contact électrique (304) d'élément émissif de montage en surface à une première interface électrique (208) d'un puits correspondant et de chaque second contact électrique (306) d'élément émissif à une seconde interface électrique (209, 310) d'un puits correspondant.

2. Procédé selon la revendication 1, dans lequel la connexion électrique de chaque élément émissif (302) comporte la connexion de chaque élément émissif (302) aux première et seconde interfaces électriques (208, 209, 310) sans la formation de couches métalliques sus-jacentes, de traces conductrices supplémentaires ou de soudure de fils sur le substrat subséquemment au recuit.

3. Procédé selon la revendication 1, comprenant en outre :
la mise en prise d'un mécanisme auxiliaire pour distribuer les éléments émissifs (302) sélectionnés dans le groupe constitué par un balai rotatif ou non rotatif (506), un cylindre rotatif, du fluide sous pression et une vibration mécanique ; et,
la capture des éléments émissifs (302) dans les puits (204) comportant la capture des éléments émissifs (302) en réponse au mécanisme auxiliaire mis en prise avec les éléments émissifs (302) dans la suspension (300) ou la surface supérieure du substrat émissif (202).

4. Procédé selon la revendication 3, dans lequel la fourniture du substrat émissif (200) comporte la fourniture d'un substrat émissif (200) pourvu d'une longueur et d'une largeur ;
dans lequel l'écoulement de la suspension (300) à travers la surface supérieure du substrat émissif (202) comporte l'alimentation de la suspension (300) à une première vélocité dans une première direction à travers la longueur du substrat émissif (200) ;
dans lequel la mise en prise du mécanisme auxiliaire comporte la mise en prise d'une brosse (506), pourvue d'un axe de rotation (508) et d'une longueur de brosse (510) au moins égale à la largeur du substrat émissif (502), comme suit :
dans un premier passage, la translation de la longueur de brosse (510) à travers la longueur de substrat émissif (502) dans la première direction ;
simultanément au premier passage de translation de la brosse, la mise en rotation de la brosse (506) pour créer une première variance locale dans la première vélocité.

5. Procédé selon la revendication 4, dans lequel la mise en prise avec le mécanisme auxiliaire comporte :
la mise en rotation de la brosse (506) à une cadence dans une plage de 120 à 300 tours par minute ; et,
la mise en translation de la brosse (506) à une vitesse dans une plage de 3 à 10 centimètres par seconde.

6. Procédé selon la revendication 1, dans lequel la fourniture du substrat émissif (200) comporte une première interface électrique revêtue de soudure (208).

7. Procédé selon la revendication 1, dans lequel l'écoulement de la suspension (300) à travers la surface supérieure du substrat émissif (202) comporte la création d'une densité locale maximale d'éléments émissifs (302) dans la suspension (300) dans une plage de 0,3 à 0,8 monocouches.

8. Procédé selon la revendication 1, dans lequel la connexion électrique de chaque élément émissif (302) comporte la connexion électrique de chaque élément émissif (302) aux première et seconde interfaces électriques (208, 209, 310) d'un puits correspondant (204) sans l'application de pression externe sur l'élément émissif (302).

9. Procédé selon la revendication 1, dans lequel la fourniture de la suspension liquide (300) d'éléments émissifs (302) comprend la fourniture d'une suspension (300) comportant un agent de fluxage de soudure.

10. Procédé selon la revendication 1, comprenant en outre :
subséquemment à la capture des éléments émissifs (302) dans les puits (204) et avant le recuit du substrat (200), le remplissage des puits garnis de l'élément émissif (204) par un agent de fluxage de soudure.

11. Procédé selon la revendication 1, comprenant en outre :
simultanément à la capture des éléments émissifs (302) dans les puits (204), la collecte d'éléments émissifs non capturés (302) ; et,
la remise en suspension des éléments émissifs collectés (302) pour une fabrication de dispositifs d'affichage émissifs subséquente.

12. Procédé selon la revendication 1, comprenant en outre :
la formation d'une pluralité de modificateurs de couleur recouvrant les surfaces exposées d'une pluralité correspondante d'éléments émissifs (302).

13. Procédé selon la revendication 1, comprenant en outre :
la formation d'une pluralité de diffuseurs de lumière recouvrant une pluralité correspondante d'éléments émissifs (302).

14. Procédé selon la revendication 1, dans lequel la fourniture de la suspension liquide d'éléments émissifs (302) comporte la fourniture d'un liquide choisi dans le groupe constitué par des alcools, des polyols, des cétones, des halocarbures et de l'eau.

15. Procédé selon la revendication 1, dans lequel la fourniture de la suspension liquide d'éléments émissifs (302) comporte la fourniture d'éléments émissifs (302) pourvus d'un contact électrique revêtu de soudure.

16. Procédé selon la revendication 1, dans lequel les étapes de fourniture d'une suspension liquide (300) d'éléments émissifs (302), d'écoulement de la suspension (300) à travers la surface supérieure du substrat émissif (202), de capture des éléments émissifs (302) dans les puits (204) et de recuit du substrat émissif (200) comprennent :
la fourniture d'une première suspension liquide avec un premier type d'éléments émissifs (812, 904) ;
l'écoulement de la première suspension à travers la surface supérieure du substrat émissif (202) ;
la capture du premier type d'éléments émissifs (812, 904) dans les puits (804, 900) ;
la fourniture d'une deuxième suspension liquide avec un deuxième type d'éléments émissifs (808, 906) ;
l'écoulement de la deuxième suspension à travers la surface supérieure du substrat émissif (202) ;
la capture du deuxième type d'éléments émissifs (808, 906) dans les puits (800, 902) ; et
l'exécution d'un recuit final du substrat émissif (200).

17. Procédé selon la revendication 16, comprenant en outre :
avant le recuit final, la fourniture d'une troisième suspension liquide avec un troisième type d'éléments émissifs de montage en surface ; et,
l'écoulement de la troisième suspension à travers la surface supérieure du substrat émissif (202).

18. Procédé selon la revendication 16, dans lequel la fourniture des puits de substrat émissifs (204) comporte
la fourniture d'une pluralité de puits circulaires (804) pourvus d'un premier diamètre (806), et la fourniture d'une pluralité de puits circulaires (800) pourvus d'un deuxième diamètre (802), inférieur au premier diamètre (806) ;
dans lequel la fourniture de la première suspension liquide comporte la fourniture d'un premier type de disques d'éléments émissifs (812) pourvus d'une forme ronde ayant un troisième diamètre (814) supérieur au deuxième diamètre (802) et inférieur au premier diamètre (806) ; et,
dans lequel la fourniture de la deuxième suspension liquide comporte la fourniture d'un second type de disques d'éléments émissifs (808) pourvus d'une forme ronde ayant un quatrième diamètre (810) inférieur au deuxième diamètre (802).

19. Procédé selon la revendication 16, dans lequel la fourniture des puits de substrat émissif (204) comporte
la fourniture d'une pluralité de puits pourvus d'une première forme (900) et la fourniture d'une pluralité de puits pourvus d'une deuxième forme (902), différente de la première forme (900) ;
dans lequel la fourniture de la première suspension liquide comporte la fourniture d'un premier type d'élément émissif pourvu de la troisième forme (904) capable de remplir les puits de première forme (900), mais incapable de remplir les puits de deuxième forme (902) ; et,
dans lequel la fourniture de la deuxième suspension liquide comporte la fourniture d'un deuxième type d'élément émissif pourvu d'une quatrième forme (906) capable de remplir les puits de deuxième forme (902).

20. Procédé selon la revendication 16, comprenant en outre :
avant l'écoulement de la deuxième suspension, l'exécution d'un recuit initial.

21. Procédé selon la revendication 1, dans lequel les étapes de fourniture d'un substrat émissif (200), de fourniture d'une suspension liquide (300) d'éléments émissifs (302) et de capture des éléments émissifs (302) dans les puits (204) comprennent :
la fourniture d'une pluralité de puits pourvus d'une première forme (900) et d'une pluralité de puits pourvus d'une deuxième forme (902), différente de la première forme (900) ;
la fourniture d'une suspension liquide (300) d'un premier type d'éléments émissifs et d'un deuxième type d'éléments émissifs,
dans lequel chacun du premier type d'éléments émissifs est pourvu d'une troisième forme (904) capable de remplir les puits de première forme (900), mais incapable de remplir les puits de deuxième forme (902) et chacun du deuxième type d'éléments émissifs est pourvu d'une quatrième forme (906) capable de remplir les puits de deuxième forme (902), mais incapable de remplir les puits de première forme (900) ; et
dans lequel la capture du premier type d'éléments émissifs dans les puits et la capture du deuxième type d'éléments émissifs dans les puits comportent la capture du premier type d'éléments émissifs dans les puits de première forme (900) et du deuxième type d'éléments émissifs dans les puits de deuxième forme (902).
